# EUROPÄISCHE PATENTANMELDUNG

(11) **EP 1 321 887 A1**
(43) Veröffentlichungstag der Anmeldung: **25.06.2003**
(21) Anmeldenummer: 02102787.5
(22) Anmeldetag: 18.12.2002
(51) Int. Cl.: G06K 19/073, G11C 8/20, G11C 16/22, G11C 7/24

(54) **Verfahren und Anordnung zur Verifikation von NV-Fuses sowie ein entsprechendes Computerprogrammprodukt und ein entsprechendes computerlesbares Speichermedium**

(30) Priorität: 19.12.2001 DE 10162306
(71) Anmelder: Philips Intellectual Property & Standards GmbH, 20099 Hamburg (DE); Koninklijke Philips Electronics N.V., 5621 BA Eindhoven (NL)
(72) Erfinder: Müller, Detlef, Postfach 500442 52088 Aachen (DE)
(74) Vertreter: Volmer, Georg, Dipl.-Ing.

(57) **Zusammenfassung**

Die Erfindung betrifft ein Verfahren und eine Anordnung zur Verifikation von NV-Fuses sowie ein entsprechendes Computerprogrammprodukt und ein entsprechendes computerlesbares Speichermedium, die insbesondere genutzt werden können, um Angriffe auf die Smartcard-Security, welche EEPROM-Inhalte und damit auch die Inhalte von EEPROM-Fuses verändern, zu detektieren.

Während der Reset-Phase werden die Fuses aus dem EEPROM ausgelesen. Dabei werden die nacheinander gelesenen Fuse-Werte automatisch verifiziert. Eine mögliche Realisierung ist zum Beispiel das Einspeisen der gelesenen Fuse-Werte in ein Signaturregister mit anschließendem Vergleich gegen einen Sollwert. Sollte die automatische Verifikation beispielsweise wegen unbefugt veränderten Fuses oder einem Angriff auf den Boot-Vorgang einen Fehler melden, können geeignete Sicherheitsmaßnahmen aktiviert werden.

## Beschreibung

Die Erfindung betrifft ein Verfahren und eine Anordnung zur Verifikation von NV-Fuses sowie ein entsprechendes Computerprogrammprodukt und ein entsprechendes computerlesbares Speichermedium, die insbesondere genutzt werden können, um Angriffe auf die Smartcard-Security, welche EEPROM-Inhalte und damit auch die Inhalte von EEPROM-Fuses verändern, zu detektieren.

Die Entwicklung der Mikroelektronik in den 70er-Jahren ermöglichte es, kleine Computer im Kreditkartenformat ohne Benutzungsschnittstelle herzustellen. Solche Computer werden als Smartcards bezeichnet. In einer Smartcard sind Datenspeicher und arithmetisch-logische Einheit in einem einzigen Chip von wenigen Quadratmillimetern Größe integriert. Smartcards werden insbesondere als Telefonkarten, GSM-SIM-Karten, im Bankenbereich und im Gesundheitswesen eingesetzt. Die Smartcard ist damit zur allgegenwärtigen Rechenplattform geworden.

Smartcards werden derzeit vornehmlich als sicherer Aufbewahrungsort für geheime Daten und als sichere Ausführungsplattform für kryptographische Algorithmen betrachtet. Die Annahme einer relativ hohen Sicherheit der Daten und Algorithmen auf der Karte liegt im Hardwareaufbau der Karte und den nach außen geführten Schnittstellen begründet. Die Karte stellt sich nach außen als "Black Box" dar, deren Funktionalität nur über eine wohldefinierte Hardware- und Softwareschnittstelle in Anspruch genommen werden kann, und die bestimmte Sicherheitspolicies erzwingen kann. Zum einen kann der Zugriff auf Daten an bestimmte Bedingungen geknüpft werden. Kritische Daten, wie zum Beispiel geheime Schlüssel eines Public-Key-Verfahrens, können dem Zugriff von außen sogar völlig entzogen werden Zum anderen ist eine Smartcard in der Lage, Algorithmen auszuführen, ohne dass die Ausführung der einzelnen Operationen von außen beobachtet werden kann. Die Algorithmen selbst können auf der Karte vor Veränderung und Auslesen geschützt werden. Im objektorientierten Sinn läßt sich die Smartcard als abstrakter Datentyp auffassen, der über eine wohldefinierte Schnittstelle verfügt, ein spezifiziertes Verhalten aufweist und selbst in der Lage ist, die Einhaltung bestimmter Integritätsbedingungen bezüglich seines Zustandes sicherzustellen.

Es gibt im Wesentlichen zwei verschiedene Typen von Smartcards. Speicherkarten besitzen lediglich eine serielle Schnittstelle, eine Adressierungs- und Sicherheitslogik und ROM- und EEPROM-Speicher. Diese Karten besitzen nur eingsschränkte Funktionalität und dienen einer spezifischen Anwendung. Dafür sind sie besonders billig herzustellen. Als Mikroprozessorkarten hergestellte Smartcards stellen im Prinzip einen vollständigen Universalrechner dar.

Der Herstellungs- und Auslieferungsprozess für Chipkarten gliedert sich in folgende Phasen:
- Herstellen des Halbleiters,
- Einbetten des Halbleiters,
- Bedrucken der Karte,
- Personalisierung der Karte,
- Ausgeben der Karte.

Im Allgemeinen wird jede Phase von einer auf die jeweilige Arbeit spezialisierten Firma durchgeführt. Beim Herstellen der Halbleiter ist insbesondere bei Karten mit festverdrahteter Sicherheitslogik auf eine gute betriebsinterne Sicherheit zu achten. Damit vom Hersteller ein korrekter Endtest durchgeführt werden kann, muß der komplette Speicher frei zugänglich sein. Erst nach dem Endtest wird der Chip durch einen Transportcode gesichert. Danach ist der Zugriff auf den Kartenspeicher nur für berechtigte Stellen, die den Transportcode kennen, möglich. Ein Diebstahl fabrikneuer Halbleiter bleibt damit ohne Folgen. Berechtigte Stellen können Personalisierer beziehungsweise Kartenausgeber sein. Für das Einbetten und Bedrucken sind keine weiteren Sicherungsfunktionen notwendig. Die betreffenden Firmen brauchen den Transportcode nicht zu kennen.

Im Allgemeinen überträgt nicht der Kartenhersteller, sondern die ausgebende Stelle (zum Beispiel Bank, Telefongesellschaft, Krankenkasse etc.) die personenspezifischen Daten in die Karte. Diesen Vorgang nennt man Personalisierung. Für sie ist die Kenntnis des Transportcodes notwendig.

Das Ausgeben der Karte, also der Transport von der ausgebenden Stelle zum Karteninhaber, stellt ein weiteres Sicherheitsproblem dar. Genau genommen ist nur die persönliche Ausgabe an den Karteninhaber gegen Unterschrift und Vorlage des Personalausweises sicher. Ein Versand per Post ist zwar oft wirtschaftlicher aber auch ziemlich unsicher. Ein Problem ist auch das Übermitteln der PIN an den Karteninhaber, hier muß die gleiche Sorgfalt wie für die Karte gelten.

Bedingt durch die brisanten, sicherheitsrelevanten Inhalte der auf Smartcard-Controllern befindlichen Speicher, ist neben der Beachtung dieser Sicherungsmaßnahmen ein zusätzlicher Schutz gegen mögliche Aktivitäten von Hackern zu gewährleisten, die sich auf alle Phasen des Lebenslaufes einer Smartcard - beginnend von der Herstellung über Transport, Nutzung der Karte bis zu Manipulationen unbrauchbar gewordener Karten - erstrecken.

Um eine möglichst hohe Sicherheit der Smartcard-Controller zu gewährleisten, werden zur Einstellung verschiedener Zustände (zum Beispiel Test/User mode, Konfigurationen, Trimmparameter für analoge Schaltungsteile etc.) EEPROM-Fuses verwendet. Diese Fuses zeichnen sich u. a. dadurch aus, dass sie programmierbar sind, und damit nicht einen unter allen Umständen sicheren physikalischen Zustand haben. Es sind generell Angriffe auf die Smartcard-Security denkbar, die EEPROM-Inhalte und damit auch die Inhalte von EEPROM-Fuses verändern können.

Automatisches, aber unverifiziertes Auslesen von EEPROM-Fuses mittels Boot-Sequenz während der Reset-Phase wird bereits durchgeführt. Manipulationen der Fuse-Werte, die entweder durch Manipulation der Inhalte der Fuse-Zellen oder Manipulationen beim Auslesen vorgenommen werden, werden nicht erkannt und können einem Angreifer irregulären Zugang beispielsweise zu einer Smartcard ermöglichen.

Die US-Patentschrift US 5,469,557 beschreibt eine Microcontroller-Anordnung, welche eine CPU, Programmspeicher zum Speichern von Anweisungen, welche von der CPU ausgeführt werden und Datenspeicher umfaßt. Der Inhalt eines jeden Speichers ist durch eine EEPROM-Fuse geschützt und wird automatisch gelöscht, wenn der Code der EEPROM-Fuse verändert wurde.

In der Schrift WO 00/19224 ist eine Schaltungsanordnung mit deaktivierbarem Scanpfad beschrieben. Dabei weist die Schaltungsanordnung eine Anzahl von Funktionsblöcken (FB1 ... FBn) auf, wobei jeder der Funktionsblöcke mit zumindest einem der anderen Funktionsblöcke verbunden ist und zumindest eine Teilmenge dieser Verbindungen über je ein Verriegelungselement (SFF1 ... SFFm) realisiert ist, das über eine Aktivierleitung (Scan Enable) vom Normal- in einen Test-Modus umgeschaltet werden kann und das einen weiteren Datenein- und einen Datenausgang aufweist. Diese weiteren Datenein- und -ausgänge sind mittels Datenleitungsabschnitten (DL1 ... DL1) derart miteinander verbunden, dass die Verriegelungselemente (SFF1 ... SFFm) ein einen Scanpfad bildendes Schieberegister bilden. Entlang der Aktivierleitung (Scan Enable) und/oder der Datenleitungsabschnitte (DL1 ... DL1) ist zumindest ein elektrisch programmierbares Sicherungselement (SE) angeordnet, das die betreffende Leitung entweder unterbricht oder mit einem definierten Potential verbindet.

Angriffe auf die Smartcard Security, die EEPROM-Inhalte und damit auch die Inhalte von EEPROM-Fuses verändern, so dass zum Beispiel bereits manipulierte EEPROM-Fuses beim Reset ausgelesen werden, werden durch diese Verfahren nicht erkannt.

Der Erfindung liegt deshalb die Aufgabe zugrunde, ein Verfahren, eine Anordnung sowie ein entsprechendes Computerprogrammprodukt und ein entsprechendes computerlesbares Speichermedium der gattungsgemäßen Art anzugeben, mittels welcher die Nachteile der herkömmlichen Schutzmaßnamen behoben und insbesondere unbefugte Manipulationen von Fuse-Inhalten/Werten erkannt werden.

Erfindungsgemäß wird diese Aufgabe gelöst durch die Merkmale im kennzeichnenden Teil der Ansprüche 1, 13, 15 und 16 im Zusammenwirken mit den Merkmalen im Oberbegriff. Zweckmäßige Ausgestaltungen der Erfindung sind in den Unteransprüchen enthalten.

Ein besonderer Vorteil des Verfahrens zur Verifikation von NV-Fuses besteht darin, dass beim Auslesen von (einem) NV-Fuse-Wert(en) aus Fuse-Zellen eines nicht-flüchtigen Speichers eine automatische Verifizierung des (der) NV-Fuse-Werte(s) erfolgt.

Eine Anordnung zur automatischen Verifikation von NV-Fuses ist vorteilhafterweise so eingerichtet, dass sie einen Prozessor umfaßt, der derart eingerichtet ist, dass eine automatische Verifikation von NV-Fuses durchrührbar ist, indem beim Auslesen von NV-Fuse-Werte(n) aus Fuse-Zellen eine Verifizierung des (der) NV-Fuse-Werte(s) erfolgt.

Ein Computerprogrammprodukt zur automatischen Verifikation von NV-Fuses umfaßt ein computerlesbares Speichermedium, auf dem ein Programm gespeichert ist, das es einem Computer oder Smartcard-Controller ermöglicht, nachdem es in den Speicher des Computers oder des Smartcard-Controllers geladen worden ist, eine automatische Verifikation von NV-Fuses durchzuführen, indem beim Auslesen von NV-Fuse-Wert(en) aus Fuse-Zellen eine Verifizierung des (der) NV-Fuse-Werte(s) erfolgt.

Um eine automatische Verifikation von NV-Fuses durchzuführen, wird vorteilhafterweise ein computerlesbares Speichermedium eingesetzt, auf dem ein Programm gespeichert ist, das es einem Computer oder Smartcard-Controller ermöglicht, nachdem es in den Speicher des Computers oder des Smartcard-Controllers geladen worden ist, die automatische Verifikation von NV-Fuses durchzuführen, indem beim Auslesen von NV-Fuse-Wert(en) aus Fuse-Zellen eine Verifizierung des (der) NV-Fuse-Werte(s) erfolgt.

Ein weiterer Vorteil des erfindungsgemäßen Verfahrens besteht darin, dass der (die) NV-Fuse-Wert(e) in dem EEPROM eines Microcontrollers, insbesondere eines Smartcard-Controllers, gespeichert ist (sind). In bevorzugter Ausgestaltung des erfindungsgemäßen Verfahrens ist vorgesehen, dass das Auslesen mittels Boot-Sequenz während der Reset-Phase erfolgt.

Als vorteilhaft erweist es sich, dass die Verifizierung des (der) NV-Fuse-Werte(s) erfolgt, indem der (die) gelesene(n) NV-Fuse-Wert(e) in eine Akkumulationseinheit eingespeist wird (werden) und anschließend ein Vergleich gegen einen Sollwert erfolgt. Darüber hinaus ist in bevorzugter Ausgestaltung des erfindungsgemäßen Verfahrens vorgesehen, dass die Verifizierung des (der) NV-Fuse-Werte(s) Abgleichwerte und/oder Konfigurationen berücksichtigt.

Zur automatischen Verifikation von NV-Fuses kann es sich als vorteilhaft erweisen, dass als Akkumulationseinheit ein Signaturregister verwendet wird. In weiterer bevorzugter Ausgestaltung des erfindungsgemäßen Verfahrens ist vorgesehen, dass der Sollwert ebenfalls ein NV-Fuse-Werte ist.

Ein weiterer Vorteil des erfindungsgemäßen Verfehrens besteht darin, dass bei Fehlermeldung während der Verifizierung des (der) NV-Fuse-Werte(s) Sicherheitsmaßnahmen eingeleitet werden. Als vorteilhaft erweist es sich, dass die Sicherheitsmaßnahmen in
- einem Reset und/oder
- dem Löschen des gesamten EEPROMs oder
- Sperren ausgewählter Funktionen
bestehen.

Darüber hinaus ist es ein Vorteil des erfindungsgemäßen Verfahrens, dass erforderlichenfalls, insbesondere im Testmode, die Verifizierung des (der) NV-Fuse-Werte(s) deaktiviert wird. Eine weitere vorteilhafte Ausführung des erfindungsgemäßen Verfahrens besteht darin, dass zur Deaktivierung der Verifizierung des (der) NV-Fuse-Werte(s) eine Hardware-Trapdoor verwendet wird. Ein Vorteil des erfindungsgemäßen Verfahrens besteht auch darin, dass zum Schutz des Microcontrollers bei deaktivierter Verifizierung des (der) NV-Fuse-Werte(s) ein Paßwort genutzt wird.

Eine vorteilhafte Ausführung der erfindungsgemäßen Anordnung besteht darin, dass der Prozessor Teil eines Smartcard-Controllers und die Anordnung eine Smartcard ist.

Ein wichtiger Vorteil der Erfindung besteht vor allem darin, dass damit Angriffe auf die Smartcard-Security, die EEPROM-Inhalte und damit auch die Inhalte von EEPROM-Fuses verändern können, erkannt werden, und man in der Lage ist, entsprechend auf diese Attacken zu reagieren, zum Beispiel durch Sperren der Karte oder andere Maßnahmen, die eine Ausführung von Anwender-Applikationen mit manipulierten Fuse-Werten verhindern.

Die Erfindung wird nachfolgend in einem Ausführungsbeispiel näher erläutert.

Bei der Anwendung der Erfindung werden während der Reset-Phase die Fuses nacheinander mittels einer Boot-Sequenz aus dem EEPROM ausgelesen. Der wesentliche Punkt hierbei besteht nun darin, dass die nacheinander gelesenen Fuse-Werte automatisch verifiziert werden. Eine mögliche Realisierung ist zum Beispiel das Einspeisen der gelesenen Fuse-Werte in eine Akkumulationseinheit (zum Beispiel ein Signaturregister) mit anschließendem Vergleich gegen einen Sollwert. Der Sollwert seinerseits kann zum Beispiel auch ein EEPROM-Fuse-Wert sein, um gegebenenfalls Abgleichwerte oder Konfigurationen mit in die Verifikation der Fuses aufnehmen zu können. Sollte die automatische Verifikation beispielsweise wegen unbefugt veränderten Fuses oder einem Angriff auf den Boot-Vorgang einen Fehler melden, können geeignete Sicherheitsmaßnahmen aktiviert werden, die zum Beispiel in einem Reset oder auch im Löschen des gesamten EEPROMs oder im Sperren bestimmter Funktionen bestehen können.

Da der Inhalt eines EEPROMs nach der Produktion des Siliziums undefiniert ist, muß die automatische Fuse-Verifikation mit Hilfe einer Hardware-Trapdoor, mit der man auch in den Testmode gelangt, abgeschaltet werden. Eine Ausführung der Anwender-Applikation mit manipulierten Fuses ist somit ausgeschlossen, während der Testmode durch zusätzliche Schutzmaßnahmen, wie zum Beispiel die Verwendung eines Paßworts, vor unbefugter Benutzung geschützt ist.

Die Erfindung ist nicht beschränkt auf die hier dargestellten Ausführungsbeispiele. Vielmehr ist es möglich, durch Kombination und Modifikation der genannten Mittel und Merkmale weitere Ausführungsvarianten zu realisieren, ohne den Rahmen der Erfindung zu verlassen.

## Patentansprüche

1. Verfahren zur Verifikation von NV-Fuses
**dadurch gekennzeichnet,**
**dass** beim Auslesen von (einem) NV-Fuse-Wert(en) aus Fuse-Zellen eines nicht-flüchtigen Speichers eine automatische Verifizierung des (der) NV-Fuse-Werte(s) erfolgt.

2. Verfahren nach Anspruch 1,
**dadurch gekennzeichnet,**
**dass** der (die) NV-Fuse-Wert(e) in dem EEPROM eines Microcontrollers, insbesondere eines Smartcard-Controllers, gespeichert ist (sind).

3. Verfahren nach einem der vorhergehenden Ansprüche,
**dadurch gekennzeichnet,**
**dass** das Auslesen mittels Boot-Sequenz während der Reset-Phase erfolgt.

4. Verfahren nach einem der vorhergehenden Ansprüche,
**dadurch gekennzeichnet,**
**dass** die Verifizierung des (der) NV-Fuse-Werte(s) erfolgt, indem der (die) gelesene(n) NV-Fuse-Wert(e) in eine Akkumulationseinheit eingespeist wird (werden) und anschließend ein Vergleich gegen einen Sollwert erfolgt.

5. Verfahren nach einem der vorhergehenden Ansprüche,
**dadurch gekennzeichnet,**
**dass** die Verifizierung des (der) NV-Fuse-Werte(s) Abgleichwerte und/oder Konfigurationen berücksichtigt.

6. Verfahren nach einem der vorhergehenden Ansprüche,
**dadurch gekennzeichnet,**
**dass** als Akkumulationseinheit ein Signaturregister verwendet wird.

7. Verfahren nach einem der vorhergehenden Ansprüche,
**dadurch gekennzeichnet,**
**dass** der Sollwert ebenfalls ein NV-Fuse-Werte ist.

8. Verfahren nach einem der vorhergehenden Ansprüche,
**dadurch gekennzeichnet,**
**dass** bei Fehlermeldung während der Verifizierung des (der) NV-Fuse-Werte(s) Sicherheitsmaßnahmen eingeleitet werden.

9. Verfahren nach einem der vorhergehenden Ansprüche,
**dadurch gekennzeichnet,**
**dass** die Sicherheitsmaßnahmen in
- einem Reset und/oder
- dem Löschen des gesamten EEPROMs oder
- Sperren ausgewählter Funktionen
bestehen.

10. Verfahren nach einem der vorhergehenden Ansprüche,
**dadurch gekennzeichnet,**
**dass** erforderlichenfalls, insbesondere im Testmode, die Verifizierung des (der) NV-Fuse-Werte(s) deaktiviert wird.

11. Verfahren nach einem der vorhergehenden Ansprüche,
**dadurch gekennzeichnet,**
**dass** zur Deaktivierung der Verifizierung des (der) NV-Fuse-Werte(s) eine Hardware-Trapdoor verwendet wird.

12. Verfahren nach einem der vorhergehenden Ansprüche,
**dadurch gekennzeichnet,**
**dass** zum Schutz des Microcontrollers bei deaktivierter Verifizierung des (der) NV-Fuse-Werte(s) ein Passwort genutzt wird.

13. Anordnung mit einem Prozessor, der derart eingerichtet ist, dass eine automatische Verifikation von NV-Fuses durchführbar ist, indem beim Auslesen von NV-Fuse-Werte(n) aus Fuse-Zellen eine Verifizierung des (der) NV-Fuse-Werte(s) erfolgt.

14. Anordnung mit einem Prozessor nach Anspruch 13,
**dadurch gekennzeichnet,**
**dass** der Prozessor Teil eines Smartcard-Controllers und die Anordnung eine Smartcard ist.

15. Computerprogrammprodukt, das ein computerlesbares Speichermedium umfaßt, auf dem ein Programm gespeichert ist, das es einem Computer oder Smartcard-Controller ermöglicht, nachdem es in den Speicher des Computers oder des Smartcard-Controllers geladen worden ist, eine automatische Verifikation von NV-Fuses durchzuführen, indem beim Auslesen von NV-Fuse-Werte(n) aus Fuse-Zellen eine Verifizierung des (der) NV-Fuse-Werte(s) erfolgt.

16. Computerlesbares Speichermedium, auf dem ein Programm gespeichert ist, das es einem Computer oder Smartcard-Controller ermöglicht, nachdem es in den Speicher des Computers oder des Smartcard-Controllers geladen worden ist, eine automatische Verifikation von NV-Fuses durchzuführen, indem beim Auslesen von NV-Fuse-Werte(n) aus Fuse-Zellen eine Verifizierung des (der) NV-Fuse-Werte(s) erfolgt.
